# FASCICULE DE BREVET EUROPEEN

(11) **EP 1 472 386 B1**
(45) Date de publication et mention de la délivrance du brevet: **16.04.2008**
(21) Numéro de dépôt: 03718834.9
(22) Date de dépôt: 04.02.2003
(51) Int. Cl.: C23C 14/34, G02F 1/15, C04B 35/00, C23C 14/08

(54) **CIBLE CERAMIQUE NiOx NON STOECHIOMETRIQUE**
NICHTSTÖCHIOMETRISCHES NIOX-KERAMIK-TARGET
NON-STOICHIOMETRIC NIOX CERAMIC TARGET

(30) Priorité: 06.02.2002 FR 0201528
(43) Date de publication de la demande: 03.11.2004
(73) Titulaire: SAINT-GOBAIN GLASS FRANCE, 92400 Courbevoie (FR)
(72) Inventeur: FANTON, Xavier, F-93600 Aulnay Sous Bois (FR); GIRON, Jean-Christophe, F-52074 Aachen (DE)
(74) Mandataire: Colombier, Christian
(86) Numéro de dépôt international: PCT/FR2003/000340
(87) Numéro de publication internationale: WO 2003/066928

(56) Documents cités:
- FR-A- 2 793 888
- US-A- 4 107 019
- US-A- 5 981 092
- PATENT ABSTRACTS OF JAPAN vol. 014, no. 004 (P-986), 9 janvier 1990 (1990-01-09) & JP 01 256036 A (TOSHIBA CORP), 12 octobre 1989 (1989-10-12)
- WEN S-J ET AL: "Analysis of durability in lithium nickel oxide electrochromic materials and devices" SOLAR ENERGY MATERIALS AND SOLAR CELLS, ELSEVIER SCIENCE PUBLISHERS, AMSTERDAM, NL, vol. 56, no. 3-4, janvier 1999 (1999-01), pages 299-307, XP004154416 ISSN: 0927-0248
- RUBIN M ET AL: "Electrochromic lithium nickel oxide by pulsed laser deposition and sputtering" SOLAR ENERGY MATERIALS AND SOLAR CELLS, ELSEVIER SCIENCE PUBLISHERS, AMSTERDAM, NL, vol. 54, no. 1-4, juillet 1998 (1998-07), pages 59-66, XP004148874 ISSN: 0927-0248

## Description

La présente invention est relative à une cible essentiellement en céramique destinée à être utilisée pour le dépôt de films, au sein d'un dispositif de pulvérisation cathodique, notamment assistée par un champ magnétique ainsi que l'utilisation de cette cible.

Elle vise plus précisément une cible céramique en nickel ainsi qu'un procédé de dépôt de couches ou films d'oxyde de nickel ou d'alliages d'oxyde de nickel à partir de cette cible par pulvérisation magnétron en mode DC ou pulsé.

Les films d'oxyde de nickel sont couramment employés dans plusieurs types applications. Ainsi par exemple, on les rencontre dans des dispositifs électrochromes, dans des dispositifs photovoltaïques (US 4.892.594, US 5.614.727) ou dans des dispositifs d'enregistrement (JP 02056747).

Ces films d'oxyde de nickel, de façon connue, sont déposés sur un substrat par sol-gel à partir de précurseurs adaptés, ou par électro-déposition à partir de solutions aqueuses de sels de nickel.

Lorsque les films d'oxyde de nickel sont incorporés dans des dispositifs électrochromes du type tout-solide, un mode est de les déposer par pulvérisation magnétron réactive. L'ensemble des couches minces est alors déposé par pulvérisation magnétron réactive sans rupture de procédé.

Lorsque ces films d'oxyde de nickel sont utilisés au sein de dispositifs électrochromes en tant que matériau à coloration anodique, on sait que les caractéristiques électriques et lumineuses de ces films dépendent fortement de leur stoechiométrie et il est souhaitable de la contrôler finement afin d'optimiser la fonctionnalité du dispositif complet : le contraste, les propriétés optiques à l'état décoloré et à l'état coloré dépendent des caractéristiques de la couche d'oxyde de nickel.

Dans les dispositifs électrochromes connus, les films d'oxyde de nickel sont déposés par pulvérisation réactive à partir d'une cible métallique de nickel dans une atmosphère d'argon et d'oxygène ou d'argon, d'oxygène et d'hydrogène.

Dans ce mode d'élaboration, il se produit un phénomène d'hystérésis avec une discontinuité de la vitesse de dépôt et de la tension ou du courant de la décharge en fonction de la proportion d'oxygène dans la chambre. Lorsque la quantité d'oxygène est faible, le film est absorbant et de caractère métallique. Le basculement dans le mode oxyde se produit au-delà d'une quantité d'oxygène donnée qui dépend des caractéristiques opératoires (pression de travail, puissance surfacique...). Lorsque des films d'oxyde de nickel sont déposés par pulvérisation magnétron réactive à partir de cibles de nickel métalliques, les films sont suroxydés par rapport au composé stoechiométrique. Le degré d'oxydation de certains Ni est alors plus élevé (Ni III au lieu de Ni II) et le film est brun. Le dépôt par pulvérisation magnétron réactive à partir de cibles métalliques ne permet pas un contrôle aisé de la stoechiométrie du film déposé.

Une première méthode permettant de contrôler la stoechiométrie des films déposés a été développée, celle-ci consiste à déposer les films à partir de cibles frittées d'oxyde de nickel en NiO. Or dans ce type de technologie, les cibles sont isolantes et l'emploi du mode radio fréquence ou « RF » est nécessaire, la vitesse de dépôt est alors beaucoup plus lente qu'en mode DC et le procédé n'est pas extrapolable sur une ligne de dépôt industrielle.

La présente invention vise donc à pallier les inconvénients des cibles utilisés dans les procédés précédents en proposant une cible céramique d'oxyde de nickel autorisant un mode de dépôt industriel de films d'oxyde de nickel ou d'alliages d'oxyde de nickel par pulvérisation magnétron en mode DC ou en mode pulsé (jusqu'à environ 400 kHz, préférentiellement 5 à 100 kHz) qui soit stable et qui permette de contrôler la stoechiométrie des films déposés.

A cet effet, la présente invention a ainsi pour objet une cible essentiellement en céramique de dispositif de pulvérisation cathodique, notamment assistée par champ magnétique, ladite cible comprenant màjoritairement de l'oxyde de nickel, caractérisée en ce que l'oxyde de nickel NiOₓ est déficient en oxygène par rapport à la composition stoechiométrique entre, et en ce que la cible comporte une résistivité électrique inférieure à 10 ohm.cm et de préférence inférieure à 1 ohm.cm, et de manière encore plus préférentielle inférieure à 0.1 ohm.cm.

Grâce à ces dispositions, le phénomène d'hystérésis ne se produit pas et le contrôle des caractéristiques du film est aisé.

Dans des modes de réalisation préférés de l'invention, on peut éventuellement avoir recours en outre à l'une et/ou à l'autre des dispositions suivantes :
- le facteur x est strictement inférieur à 1,
- la déficience toechiométrique provient de la composition du mélange intime formé par des poudres d'oxyde de nickel et des poudres de nickel,
- l'oxyde de nickel est allié à un élément minoritaire,
- un élément est dit minoritaire lorsque le pourcentage atomique de l'élément en question est inférieur à 50 %, et de préférence inférieur à 30 %, et encore de façon encore plus préférentielle inférieur à 20 %, calculé par rapport au nickel.
- l'élément minoritaire est un matériau dont l'oxyde est un matériau électroactif à coloration anodique,
- l'élément minoritaire est choisi parmi Co, Ir, Ru, Rh, ou un mélange de ces éléments.
- l'élément minoritaire est choisi parmi les éléments appartenant à la première colonne du tableau périodique,
- l'élément minoritaire est choisi parmi H, Li, K, Na, ou un mélange de ces éléments,
- l'élément minoritaire est un matériau dont l'oxyde est un matériau électroactif à coloration cathodique,
- l'élément minoritaire est choisi parmi Mo, W, Re, Sn, In, Bi, ou un mélange de ces éléments,
- l'élément minoritaire est un métal ou un alcalino-terreux ou un semi-conducteur, dont l'oxyde hydraté ou hydroxylé est conducteur protonique,
- l'élément minoritaire est choisi parmi Ta, Zn, Zr, Al, Si, Sb, U, Be, Mg, Ca, V, Y ou un mélange de ces éléments.

Selon un autre aspect de l'invention, celle-ci vise également un procédé de fabrication d'une couche mince à base d'oxyde de nickel par pulvérisation cathodique assistée par champ magnétique à partir d'une cible céramique telle que précédemment décrite.

Selon encore un autre aspect de l'invention, celle-ci vise également une utilisation du procédé précédent pour l'élaboration d'un matériau électrochrome à coloration anodique en couche mince à base d'oxyde de nickel.

Selon encore un autre aspect de l'invention, celle-ci vise également un dispositif électrochimique comportant au moins un substrat porteur muni d'un empilement de couches fonctionnelles dont au moins une couche électrochimiquement active susceptibles d'insérer réversiblement et simultanément des ions du type H⁺, Li⁺, OH⁻, et des électrons, ladite couche électrochimiquement active est à base d'oxyde de nickel obtenue par le procédé précédent et/ou à partir d'une cible telle que visée ci-dessus.

D'autres caractéristiques et avantages de l'invention apparaîtront au cours de la description suivante de plusieurs de ses formes de réalisation, données à titre d'exemple non limitatif. Sur les figures :
- la figure 1 est une courbe d'hystérésis obtenue avec une cible de nickel métallique ;
- la figure 2 est une courbe de réponse caractéristique d'une cible selon l'invention.

Selon un mode préféré d'élaboration des cibles céramiques objet de l'invention, celles-ci sont réalisées par pulvérisation (ou « spray coating ») en atmosphère neutre appauvrie en oxygène ou en atmosphère réductrice de poudres céramiques d'oxydes de nickel sur un support métallique (cuivre...).

Selon un autre mode de réalisation, les cibles céramiques sont réalisées par co-pulvérisation de cibles d'oxyde de nickel et de nickel métallique sur un support métallique en atmosphère neutre ou en atmosphère réductrice ou en atmosphère appauvrie en oxygène.

Selon encore un autre mode de réalisation, ces cibles céramiques sont obtenues en mélangeant intimement de la poudre d'oxyde de nickel et de la poudre de nickel métallique dans une proportion qui varie entre 70/30 et 95/5, préférentiellement entre 80/20 et 90/10 et qui vaut plus préférentiellement 85/15.

Le mélange de poudres d'oxydes de nickel ou d'oxydes de nickel et de nickel est pulvérisé par « spray coating » sur un support métallique en atmosphère neutre ou en atmosphère réductrice ou en atmosphère appauvrie en oxygène. Les poudres d'oxyde de nickel peuvent être de l'oxyde de nickel 'vert' ou de l'oxyde de nickel 'noir'. On peut aussi procéder par frittage d'un mélange de poudre réduite, voire d'un mélange intime d'oxyde de nickel et de nickel, on peut aussi procéder par mélange intime de poudres d'oxydes de nickel 'vert' et 'noir'.

Enfin selon encore un autre mode de réalisation des cibles en céramique objet de l'invention, on associe à l'élément majoritaire formé d'oxyde de nickel et/ou de nickel, un élément minoritaire.

Au sens de l'invention, un élément est dit minoritaire lorsque le pourcentage atomique de l'élément en question est inférieur à 50 %, et de préférence inférieur à 30 %, et encore de façon encore plus préférentielle inférieur à 20 %, calculé par rapport au nickel.

Cet élément minoritaire peut être choisi soit parmi ceux dont l'oxyde est un matériau électroactif à coloration anodique, tel que par exemple du Co, Ir, Ru, Rh ; soit parmi ceux qui appartiennent à la première colonne du tableau périodique (par exemple H, Li, K, Na). Cet élément minoritaire peut être utilisé seul ou en mélange.

Selon une autre variante, l'élément minoritaire est un matériau dont l'oxyde est un matériau électroactif à coloration cathodique, et dans ce cas l'élément minoritaire est choisi parmi Mo, W, Re, Sn, In, Bi, ou un mélange de ces éléments.

Selon encore une autre variante, l'élément minoritaire est un métal ou un alcalino-terreux ou un semi-conducteur, dont l'oxyde hydraté ou hydroxylé est conducteur protonique, et dans ce cas, l'élément minoritaire est choisi parmi Ta, Zn, Zr, Al, Si, Sb, U, Be, Mg, Ca, V, Y ou un mélange de ces éléments.

Quel que soit le mode de réalisation utilisé, l'oxyde de nickel NiOₓ est déficient en oxygène selon un facteur x par rapport à la composition stoechiométrique en NiO, et x est strictement inférieur à 1 et la cible céramique présente une résistivité électrique, à température ambiante, qui est inférieure à 10 ohm.cm et préférentiellement inférieure à 1 ohm.cm, et de manière encore plus préférentielle inférieure à 0.1 ohm.cm.

Au sens de l'invention, la sous stoechiométrie est calculée par rapport au composé NiO.

Ces cibles céramiques peuvent être des cibles planaires, des cibles rotatives, ou des cibles planaires utilisées en mode « twin-mag »™.

La sous-stoechiométrie en oxygène procure une conductivité électrique suffisante autorisant une alimentation desdites cibles en mode DC ou pulsé. La conductivité électrique est assurée par la présence de lacunes d'oxygène ou par un mélange intime entre de l'oxyde de nickel et du nickel métallique. La déficience stoechométrique peut aussi provenir de la composition du mélange intime formé par des poudres d'oxydes de nickel et des poudres de nickel.

A partir de ces cibles céramiques d'oxyde de nickel, il est possible de déposer sur des substrats, notamment de type verrier, des films ou couches minces d'oxyde de nickel.

On procède de la manière suivante :

Une cible céramique NiOₓ, objet de l'invention, est montée sur un bâti de pulvérisation magnétron. La pulvérisation est préférablement réalisée avec comme gaz plasmagène de l'argon, de l'azote, de l'oxygène, un mélange d'argon et d'oxygène, un mélange d'argon, d'oxygène et d'hydrogène, un mélange d'oxygène et d'hydrogène, un mélange d'azote et d'oxygène ou un mélange d'azote, d'oxygène et d'hydrogène, ou encore en mélange avec ces derniers des gaz rares.

Selon la proportion d'oxygène par rapport à l'argon, la stoechiométrie du film déposé est modifiée et sa transmission lumineuse également. Un mélange préférentiel de gaz pour déposer un film d'oxyde de nickel stoechiométrique contient 60-99 % par volume d'argon et 40-1 % par volume d'oxygène. La pression totale de gaz dans l'enceinte peut être comprise entre 2 x 10⁻³ mbar et 50 x 10⁻³ mbar.

Pour les applications électrochromes, le substrat sur lequel est déposé le film d'oxyde de nickel peut être un verre recouvert d'un matériau conducteur comme un oxyde transparent conducteur (OTC) ou un métal, un film plastique recouvert d'un oxyde transparent conducteur. L'OTC peut être de l'oxyde d'indium dopé à l'étain, communément appelée ITO, ou de l'oxyde d'étain dopé au fluor.

Dans le cas d'un verre recouvert d'un OTC une sous-couche peut être déposée entre le verre et l'OTC. La sous-couche sert de couche anti-couleur et elle est aussi une barrière à la migration des ions alcalins. Il s'agit par exemple d'une couche d'oxyde de silicium, d'une couche d'oxycarbure de silicium ou d'une couche d'oxyde de silicium nitruré ou d'une couche de nitrure de silicium ou encore d'oxyde d'Yttrium. Par la suite les autres couches composant un empilement électrochrome seront déposées par pulvérisation magnétron réactive. On peut ainsi réaliser des empilements du type Verre/SiO₂/ITO/NiOₓ/Electrolyte/WO₃/ITO. L'électrolyte a pour propriété d'être un milieu ayant une conductivité ionique élevée mais d'être un isolant électronique. Ce peut être de l'oxyde de tantale, de l'oxyde de silicium ou un oxynitrure de silicium ou un nitrure de silicium, un bicouche de matériaux électrolytes comme de l'oxyde de tungstène et de l'oxyde de tantale ou de l'oxyde de titane ou de l'oxyde de tantale, ou tous autres composés ayant ces propriétés. Au titre de l'invention on peut aussi considérer comme substrat tout substrat sur lequel aura été auparavant déposé un empilement de couches afin de réaliser un dispositif électrochrome. Ainsi l'empilement de couches peut être Verre/SiO₂/ITO/WO₃/Eiectrolyte/Nioₓ/ITO.

On donnera ci-après deux exemples de cibles, l'une (exemple 1) étant une cible métallique d'oxyde de nickel selon l'art antérieur, l'autre (exemple 2) étant une cible céramique à base d'oxyde de nickel sous stoechiométrique (selon l'invention)

### Exemple 1.

Une cible métallique de nickel de dimensions 90 mm x 210 mm a été montée sur un bâti de pulvérisation magnétron. Le substrat est un verre recouvert d'un bicouche SiO₂/ITO de résistance par carrée environ 15 ohms. Sa transmission lumineuse (moyenne intégrée dans le domaine des longueurs d'onde visibles) est supérieure à 85 %.

La cible est alimentée en mode DC sous une pression de 40 x 10⁻³ mbar. Le gaz plasmagène est un mélange d'argon et d'oxygène contenant 3.5 % d'oxygène en volume. Une quantité plus faible d'oxygène fait basculer le dépôt du mode oxyde dans le mode métallique. Ce comportement est caractéristique du fonctionnement des cibles métalliques lors d'une pulvérisation réactive. Un film d'oxyde de nickel d'épaisseur 100 nm est déposé sur le substrat. Sa transmission lumineuse est égale à 63 %. (tableau 1)

### Exemple 2.

Une cible planaire céramique d'oxyde de nickel de dimensions 90 mm x 210 mm a été montée sur un bâti de pulvérisation magnétron. Des films ont été déposés sur un verre recouvert d'un bicouche SiO₂/ITO.

La cible est alimentée en mode DC sous une pression de 40 x 10⁻³ mbar. Le gaz plasmagène est un mélange d'argon et d'oxygène dans une proportion qui varie entre 1 % d'oxygène en volume et 4 %. Le procédé est stable quelle que soit la quantité d'oxygène. Le tableau 1 indique les caractéristiques des films après dépôt.

**Tableau 1.**

| Cible | Quantité d'oxygène dans le gaz plasmagène (Vol. %) | Epaisseur (nm) | T_{L} (%) |
|---|---|---|---|
| Ni (exemple 1) | 3.4 | 100 | 63 |
| NiOₓ (exemple 2) | 1.0 | 110 | 72 |
| NiOₓ(exemple 2) | 2.1 | 90 | 64 |
| NiOx(exemple 2) | 3.2 | 80 | 61 |

L'utilisation de la cible céramique NiOₓ permet de contrôler les caractéristiques du film déposé, et en particulier sa transmission lumineuse. Le dépôt a été réalisé en mode DC et de façon stable. De plus par rapport à une cible métallique traditionnelle, le ferromagnétisme de la cible est fortement réduit.

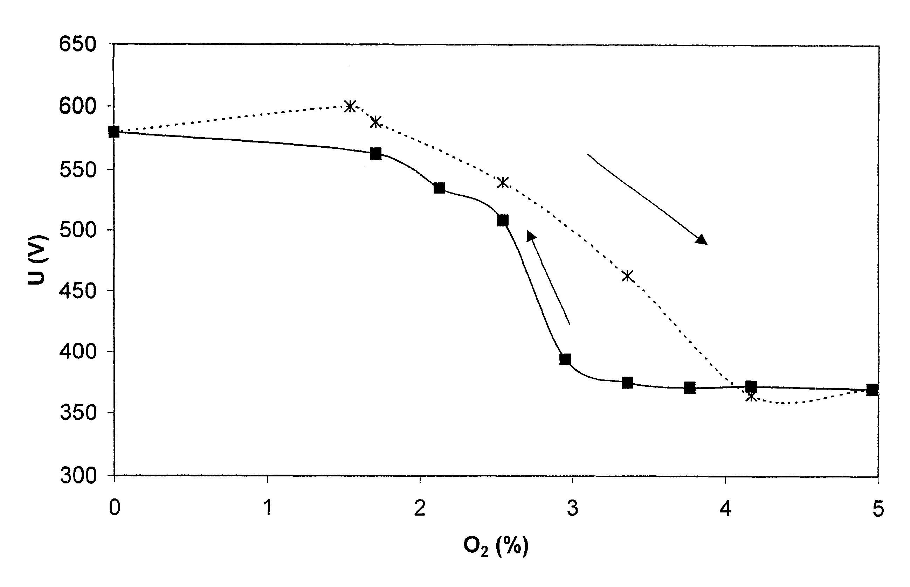

A partir de la figure 1, on suit la tension de la cible de nickel métallique en fonction de la concentration en oxygène dans l'enceinte. On remarque qu'à des faibles concentrations en oxygène, la tension est élevée et le film déposé présente un caractère métallique. Aux concentrations d'oxygène élevées, la tension est faible et le film est de type oxydé. La transition entre les deux régimes se fait de manière brutale, avec un phénomène d'hystérésis

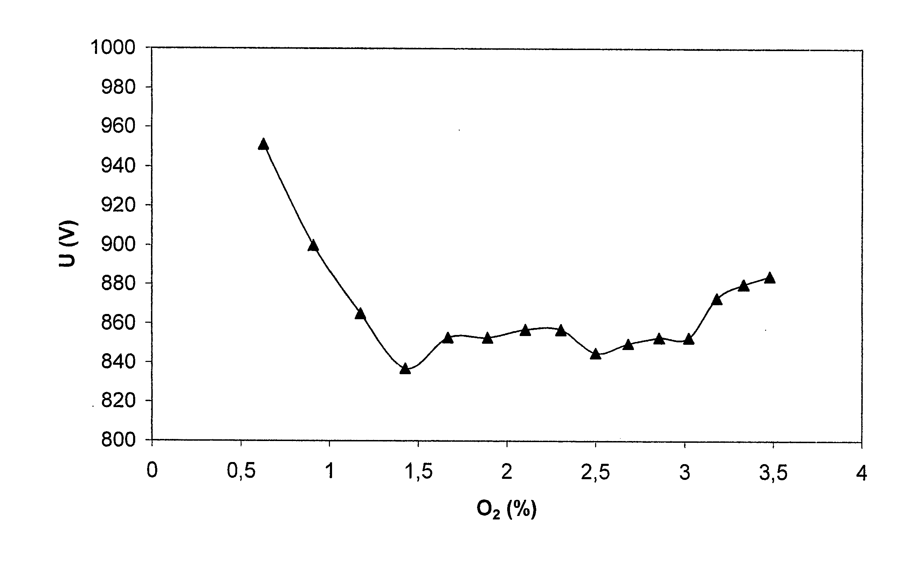

Sur la figure 2, on suit la tension de la cathode de la cible selon l'invention en fonction de la concentration en oxygène dans l'enceinte, la courbe ne présente aucune transition notable et les propriétés du film déposé évoluent de façon continue en fonction de la quantité d'oxygène, permettant ainsi de piloter, avec une meilleure stabilité le processus, tout en garantissant un contrôle optimum des propriétés des films. Cette cible permet de réaliser des dispositifs électrochimiques qui font partie de vitrages électrochromes, notamment pour bâtiment ou moyens de locomotion du type train, avion, voiture, qui font partie d'écrans de visualisation, ou qui font partie de miroirs électrochromes.

## Revendications

1. Cible essentiellement en céramique de dispositif de pulvérisation cathodique, notamment assistée par champ magnétique, ladite cible comprenant majoritairement de l'oxyde de nickel NiOₓ, **caractérisée en ce que** l'oxyde de nickel est déficient en oxygène par rapport à la composition stoechiométrique en NiO et **en ce que** x est strictement inférieur à 1, et **en ce que** la cible comporte une résistivité électrique inférieure à 10 ohm.cm et de préférence inférieure à 1 ohm.cm, et de manière plus préférentielle inférieure à 0.1 ohm.cm.

2. Cible selon la revendication 1, **caractérisée en ce que** la déficience stoechiométrique provient de la composition du mélange intime formé par des poudres d'oxyde de nickel et des poudres de nickel.

3. Cible selon l'une des revendications 1 à 2, **caractérisée en ce que** l'oxyde de nickel est allié à un élément minoritaire.

4. Cible selon la revendication 3, **caractérisé en ce que** le pourcentage atomique de l'élément minoritaire est inférieur à 50 %, de préférence inférieur à 30 %, et encore de façon encore plus préférentielle inférieur à 20 %, calculé par rapport au nickel.

5. Cible selon l'une des revendications 3 ou 4, **caractérisée en ce que** l'élément minoritaire est un matériau dont l'oxyde est un matériau électroactif à coloration anodique.

6. Cible selon la revendication 4, **caractérisée en ce que** l'élément minoritaire est choisi parmi Co, Ir, Ru, Rh,

7. Cible selon la revendication 3 ou 4, **caractérisée en ce que** l'élément minoritaire est un matériau dont l'oxyde est un matériau électroactif à coloration cathodique.

8. Cible selon la revendication 7, **caractérisée en ce que** l'élément minoritaire est choisi parmi Mo, W, Re, Sn, In, Bi, ou un mélange de ces éléments.

9. Cible selon la revendication 3 ou 4, **caractérisée en ce que** l'élément minoritaire est choisi parmi les éléments appartenant à la première colonne du tableau périodique.

10. Cible selon la revendication 9, **caractérisée en ce que** l'élément minoritaire est choisi parmi H, Li, K, Na.

11. Cible selon la revendication 3 ou 4, **caractérisée en ce que** l'élément minoritaire est un métal ou un alcalino-terreux ou un semi-conducteur, dont l'oxyde hydraté ou hydroxylé est conducteur protonique.

12. Cible selon la revendication 11, **caractérisée en ce que** l'élément minoritaire est choisi parmi Ta, Zn, Zr, Al, Si, Sb, U, Be, Mg, Ca, V, Y ou un mélange de ces éléments.

13. Procédé de fabrication d'une couche mince à base d'oxyde de nickel par pulvérisation cathodique assistée par champ magnétique **caractérisé en ce qu'il** utilise une cible céramique selon l'une quelconque des revendications 1 à 12.

14. Utilisation du procédé selon la revendication 13 pour élaborer un matériau électrochrome à coloration anodique en couche mince à base d'oxyde de nickel.

15. Dispositif électrochimique comportant au moins un substrat porteur muni d'un empilement de couches fonctionnelles dont au moins une couche électrochimiquement active susceptibles d'insérer réversiblement et simultanément des ions du type H⁺, Li⁺' OH⁻, et des électrons, **caractérisé en ce que** ladite couche électrochimiquement active est à base d'oxyde de nickel obtenue par le procédé selon la revendication 13 et/ou à partir d'une cible selon l'une des revendications 1 à 12.

16. Dispositif électrochimique comportant au moins un substrat porteur muni d'un empilement de couches fonctionnelles dont au moins une couche électrochimiquement active susceptibles d'insérer réversiblement et simultanément des ions du type H⁺, Li⁺' OH⁻, et des électrons, **caractérisé en ce que** ladite couche électrochimiquement active est à base d'oxyde de nickel, ladite couche étant alliée à un élément minoritaire constituée en un matériau dont l'oxyde est un matériau électroactif à coloration anodique, notamment choisi parmi Co, Ir, Ru, Rh ou un mélange de ces éléments, ladite couche étant obtenue à partir d'une cible selon l'une quelconque des revendications 1 à 6.

17. Dispositif électrochimique comportant au moins un substrat porteur muni d'un empilement de couches fonctionnelles dont au moins une couche électrochimiquement active susceptibles d'insérer réversiblement et simultanément des ions du type H⁺, Lf⁺' OH⁻, et des électrons, **caractérisé en ce que** ladite couche électrochimiquement active est à base d'oxyde de nickel, ladite couche étant alliée à un élément minoritaire constituée en un matériau dont l'oxyde est un matériau électroactif à coloration cathodique, notamment choisi parmi Mo, W, Re, Sn, In, Bi, ou un mélange de ces éléments, ladite couche étant obtenue à partir d'une cible selon l'une quelconque des revendications 1 à 4 et 7 à 8.

18. Dispositif électrochimique comportant au moins un substrat porteur muni d'un empilement de couches fonctionnelles dont au moins une couche électrochimiquement active susceptibles d'insérer réversiblement et simultanément des ions du type H⁺, Li⁺' OH⁻, et des électrons, **caractérisé en ce que** ladite couche électrochimiquement active est à base d'oxyde de nickel, ladite couche étant alliée à un élément minoritaire choisi parmi les éléments appartenant à la première colonne du tableau périodique, notamment choisi parmi H, Li, K, Na ou un mélange de ces éléments, ladite couche étant obtenue à partir d'une cible selon l'une quelconque des revendications 1 à 4 et 9 à 10.

19. Dispositif électrochimique comportant au moins un substrat porteur muni d'un empilement de couches fonctionnelles dont au moins une couche électrochimiquement active susceptibles d'insérer réversiblement et simultanément des ions du type H⁺, Li⁺' OH⁻, et des électrons, **caractérisé en ce que** ladite couche électrochimiquement active est un métal ou un alcalino-terreux ou un semi-conducteur, dont l'oxyde hydraté ou hydroxylé est conducteur protonique, notamment choisi parmi Ta, Zn, Zr, Al, Si, Sb, U, Be, Mg, Ca, V, Y ou un mélange de ces éléments, ladite couche étant obtenue à partir d'une cible selon l'une quelconque des revendications 1 à 4 et 11 à 12.

20. Utilisation du dispositif électrochimique selon l'une quelconque des revendications 15 à 19 pour faire partie de vitrages électrochromes, notamment pour bâtiment ou moyens de locomotion du type train, avion, voiture, pour faire partie d'écrans de visualisation, ou pour faire partie de miroirs électrochromes.

## Claims

1. Essentially ceramic target for a sputtering device, especially for magnetically enhanced sputtering, said target comprising predominantly nickel oxide NiOₓ, **characterized in that** the nickel oxide is oxygen-deficient with respect to the stoichiometric composition NiO and **in that** x is strictly less than 1 and **in that** the target has an electrical resistivity of less than 10 ohm.cm, preferably less than 1 ohm.cm, and more preferably less than 0.1 ohm.cm.

2. Target according to Claim 1, **characterized in that** the stoichiometric deficiency stems from the composition of the intimate blend formed by nickel oxide powders and nickel powders.

3. Target according to either of Claims 1 and 2, **characterized in that** the nickel oxide is alloyed to a minority element.

4. Target according to Claim 3, **characterized in that** the atomic percentage of the minority element is less than 50%, preferably less than 30% and even more preferably still less than 20%, calculated with respect to the nickel.

5. Target according to either of Claims 3 and 4, **characterized in that** the minority element is a material whose oxide is an electroactive material with anodic coloration.

6. Target according to Claim 4, **characterized in that** the minority element is chosen from Co, Ir, Ru, and Rh.

7. Target according to Claim 3 or 4, **characterized in that** the minority element is a material whose oxide is an electroactive material with cathodic coloration.

8. Target according to Claim 7, **characterized in that** the minority element is chosen from Mo, W, Re, Sn, In, and Bi or a mixture of these elements.

9. Target according to Claim 3 or 4, **characterized in that** the minority element is chosen from the elements belonging to the column one of the Periodic Table.

10. Target according to Claim 9, **characterized in that** the minority element is chosen from H, Li, K, and Na.

11. Target according to Claim 3 or 4, **characterized in that** the minority element is a metal or an alkaline earth or a semiconductor, the hydrated or hydroxylated oxide of which is protonically conductive.

12. Target according to Claim 11, **characterized in that** the minority element is chosen from Ta, Zn, Zr, Al, Si, Sb, U, Be, Mg, Ca, V, and Y or a mixture of these elements.

13. Process for manufacturing a thin layer based on nickel oxide by magnetically enhanced sputtering, **characterized in that** it uses a ceramic target according to any one of Claims 1 to 12.

14. Use of the process according to Claim 13 for producing an electrochromic material having anodic coloration as a thin layer based on nickel oxide.

15. Electrochemical device comprising at least one carrier substrate provided with a stack of functional layers, including at least one electrochemically active layer, capable of reversibly and simultaneously inserting ions, of the H⁺, Li⁺ or OH⁻ type, and electrons, **characterized in that** said electrochemically active layer is based on nickel oxide obtained by the process according to Claim 13 and/or from a target according to one of Claims 1 to 12.

16. Electrochemical device comprising at least one carrier substrate provided with a stack of functional layers, including at least one electrochemically active layer, capable of reversibly and simultaneously inserting ions, of the H⁺, Li⁺ or OH⁻ type, and electrons, **characterized in that** said electrochemically active layer is based on nickel oxide, said layer being alloyed with a minority element consisting of a material whose oxide is an electroactive material with anodic coloration, especially chosen from Co, Ir, Ru, and Rh or a mixture of these elements, said layer being obtained from a target according to any one of Claims 1 to 6.

17. Electrochemical device comprising at least one carrier substrate provided with a stack of functional layers, including at least one electrochemically active layer, capable of reversibly and simultaneously inserting ions, of the H⁺, Li⁺ or OH⁻ type, and electrons, **characterized in that** said electrochemically active layer is based on nickel oxide, said layer being alloyed with a minority element consisting of a material whose oxide is an electroactive material with cathodic coloration, especially chosen from Mo, W, Re, Sn, In, and Bi or a mixture of these elements, said layer being obtained from a target according to any one of Claims 1 to 4 and 7 to 8.

18. Electrochemical device comprising at least one carrier substrate provided with a stack of functional layers, including at least one electrochemically active layer, capable of reversibly and simultaneously inserting ions, of the H⁺, Li⁺ or OH⁻ type, and electrons, **characterized in that** said electrochemically active layer is based on nickel oxide, said layer being alloyed with a minority element chosen from the elements belonging to the column one of the Periodic Table, especially chosen from H, Li, K, and Na or a mixture of these elements, said layer being obtained from a target according to any one of Claims 1 to 4 and 9 to 10.

19. Electrochemical device comprising at least one carrier substrate provided with a stack of functional layers, including at least one electrochemically active layer, capable of reversibly and simultaneously inserting ions, of the H⁺, Li⁺ or OH⁻ type, and electrons. **characterized in that** said electrochemically active layer is a metal or an alkaline earth or a semiconductor, the hydrated or hydroxylated oxide of which is protonically conducted, especially chosen from Ta, Zn, Zr, Al, Si, Sb, U, Be, Mg, Ca, V, and Y or a mixture of these elements, said layer being obtained from a target according to any one of Claims 1 to 4 and 11 to 12.

20. Use of the electrochemical device according to any one of Claims 15 to 19 to form part of electrochromic glazing, especially for buildings or for means of locomotion of the train, aeroplane or car type, to form part of display screens or to form part of electrochromic mirrors.

## Patentansprüche

1. Target aus einem im Wesentlichen keramischen Material für eine insbesondere magnetfeldgestützte Kathodenzerstäubungsvorrichtung, das überwiegend Nickeloxid, NiOₓ, umfasst, **dadurch gekennzeichnet, dass** das Nickeloxid, bezogen auf die stöchiometrische Zusammensetzung von NiO, an Sauerstoff defizitär ist, dass x streng kleiner als 1 ist und dass das Target einen spezifischen elektrischen Widerstand von weniger als 10 Ohm·cm, vorzugsweise weniger als 1 Ohm·cm, und besonders bevorzugt weniger als 0,1 Ohm·cm besitzt.

2. Target nach Anspruch 1, **dadurch gekennzeichnet, dass** das stöchiometrische Defizit aus der Zusammensetzung des innigen Gemischs, das aus Nickeloxidpulver und Nickelpulver gebildet worden ist, herrührt.

3. Target nach Anspruch 1 oder 2, **dadurch gekennzeichnet, dass** das Nickeloxid mit einem als Nebenbestandteil fungierenden Element legiert ist.

4. Target nach Anspruch 3, **dadurch gekennzeichnet, dass** der prozentuale Atomanteil des als Nebenbestandteil fungierenden Elements weniger als 50 %, vorzugsweise weniger als 30 %, und besonders bevorzugt weniger als 20 %, berechnet in Bezug auf das Nickel, beträgt.

5. Target nach Anspruch 3 oder 4, **dadurch gekennzeichnet, dass** das als Nebenbestandteil fungierende Element ein Material ist, dessen Oxid ein elektrisch aktives Material mit anodischer Färbung ist.

6. Target nach Anspruch 4, **dadurch gekennzeichnet, dass** das als Nebenbestandteil fungierende Element aus Co, Ir, Ru und Rh ausgewählt ist.

7. Target nach Anspruch 3 oder 4, **dadurch gekennzeichnet, dass** das als Nebenbestandteil fungierende Element ein Material ist, dessen Oxid ein elektrisch aktives Material mit kathodischer Färbung ist.

8. Target nach Anspruch 7, **dadurch gekennzeichnet, dass** das als Nebenbestandteil fungierende Element aus Mo, W, Re, Sn, In und Bi oder einem Gemisch aus diesen Elementen ausgewählt ist.

9. Target nach Anspruch 3 oder 4, **dadurch gekennzeichnet, dass** das als Nebenbestandteil fungierende Element aus den Elementen ausgewählt ist, die zu der ersten Gruppe des Periodensystems gehören.

10. Target nach Anspruch 9, **dadurch gekennzeichnet, dass** das als Nebenbestandteil fungierende Element aus H, Li, K und Na ausgewählt ist.

11. Target nach Anspruch 3 oder 4, **dadurch gekennzeichnet, dass** das als Nebenbestandteil fungierende Element ein Metall, ein Erdalkalimetall oder ein Halbleiter ist, dessen hydratisiertes oder hydroxyliertes Oxid protonenleitfähig ist.

12. Target nach Anspruch 11, **dadurch gekennzeichnet, dass** das als Nebenbestandteil fungierende Element aus Ta, Zn, Zr, Al, Si, Sb, U, Be, Mg, Ca, V und Y oder einem Gemisch aus diesen Elementen ausgewählt ist.

13. Verfahren zur Herstellung einer dünnen Schicht auf der Basis von Nickeloxid durch magnetfeldgestützte Kathodenzerstäubung, **dadurch gekennzeichnet, dass** ein Keramiktarget nach einem der Ansprüche 1 bis 12 verwendet wird.

14. Anwendung des Verfahrens nach Anspruch 13 für die Herstellung eines elektrochromen Materials mit anodischer Färbung als dünne Schicht auf der Basis von Nickeloxid.

15. Elektrochemische Vorrichtung, die wenigstens ein Tragsubstrat umfasst, das mit einem Aufbau aus Funktionsschichten versehen ist, davon mindestens eine elektrochemisch aktive Schicht, die in der Lage ist, reversibel und gleichzeitig Ionen vom Typ H⁺, Li⁺ und OH- und Elektronen einzulagern, **dadurch gekennzeichnet, dass** die elektrochemisch aktive Schicht auf der Basis von Nickeloxid ist, das durch das Verfahren nach Anspruch 13 und/oder aus einem Target nach einem der Ansprüche 1 bis 12 erhalten worden ist.

16. Elektrochemische Vorrichtung, die wenigstens ein Tragsubstrat umfasst, das mit einem Aufbau aus Funktionsschichten versehen ist, davon mindestens eine elektrochemisch aktive Schicht, die in der Lage ist, reversibel und gleichzeitig Ionen vom Typ H⁺, Li⁺ und OH- und Elektronen einzulagern, **dadurch gekennzeichnet, dass** die elektrochemisch aktive Schicht auf der Basis von Nickeloxid ist, wobei diese Schicht mit einem als Nebenbestandteil fungierenden Element legiert ist, das von einem Material gebildet wird, dessen Oxid ein elektrisch aktives Material mit anodischer Färbung ist und welches insbesondere aus Co, Ir, Ru und Rh oder einem Gemisch aus diesen Elementen ausgewählt ist, und diese Schicht aus einem Target nach einem der Ansprüche 1 bis 6 erhalten worden ist.

17. Elektrochemische Vorrichtung, die wenigstens ein Tragsubstrat umfasst, das mit einem Aufbau aus Funktionsschichten versehen ist, davon mindestens eine elektrochemisch aktive Schicht, die in der Lage ist, reversibel und gleichzeitig Ionen vom Typ H⁺, Li⁺ und OH- und Elektronen einzulagern, **dadurch gekennzeichnet, dass** die elektrochemisch aktive Schicht auf der Basis von Nickeloxid ist, wobei diese Schicht mit einem als Nebenbestandteil fungierenden Element legiert ist, das von einem Material gebildet wird, dessen Oxid ein elektrisch aktives Material mit kathodischer Färbung ist und welches insbesondere aus Mo, W, Re, Sn, In und Bi oder einem Gemisch aus diesen Elementen ausgewählt ist, und diese Schicht aus einem Target nach einem der Ansprüche 1 bis 4 und 7 und 8 erhalten worden ist.

18. Elektrochemische Vorrichtung, die wenigstens ein Tragsubstrat umfasst, das mit einem Aufbau aus Funktionsschichten versehen ist, davon mindestens eine elektrochemisch aktive Schicht, die in der Lage ist, reversibel und gleichzeitig Ionen vom Typ H⁺, Li⁺ und OH⁻ und Elektronen einzulagern, **dadurch gekennzeichnet, dass** die elektrochemisch aktive Schicht auf der Basis von Nickeloxid ist, wobei diese Schicht mit einem als Nebenbestandteil fungierenden Element legiert ist, das aus den Elementen, die zur ersten Gruppe des Periodensystems gehören, und insbesondere aus H, Li, K und Na oder einem Gemisch aus diesen Elementen ausgewählt ist, wobei diese Schicht aus einem Target nach einem der Ansprüche 1 bis 4 und 9 und 10 erhalten worden ist.

19. Elektrochemische Vorrichtung, die wenigstens ein Tragsubstrat umfasst, das mit einem Aufbau aus Funktionsschichten versehen ist, davon mindestens eine elektrochemisch aktive Schicht, die in der Lage ist, reversibel und gleichzeitig Ionen vom Typ H⁺, Li⁺ und OH⁻ und Elektronen einzulagern, **dadurch gekennzeichnet, dass** die elektrochemisch aktive Schicht aus einem Metall, Erdalkalimetall oder Halbleiter besteht, dessen hydratisiertes oder hydroxyliertes Oxid protonenleitfähig ist und das (der) insbesondere aus Ta, Zn, Zr, Al, Si, Sb, U, Be, Mg, Ca, V und Y oder einem Gemisch aus diesen Elementen ausgewählt ist, wobei diese Schicht aus einem Target nach einem der Ansprüche 1 bis 4 und 11 und 12 erhalten worden ist.

20. Verwendung der elektrochemischen Vorrichtung nach einem der Ansprüche 15 bis 19 als Bestandteil elektrochromer Gläser, insbesondere für Gebäude oder selbstbewegliche Mittel vom Typ Zug, Flugzeug und Personenkraftwagen, und als Bestandteil von Bildschirmen oder elektrochromen Spiegeln.
